# EUROPEAN PATENT SPECIFICATION

(11) **EP 0 655 683 B1**
(45) Date of publication and mention of the grant of the patent: **01.09.1999**
(21) Application number: 93830478.9
(22) Date of filing: 30.11.1993
(51) Int. Cl.: G06F 11/267, G11C 29/00

(54) **Circuit architecture and corresponding method for testing a programmable logic matrix**
Schaltungsarchitektur und Verfahren zur Prüfung einer programmierbaren Logikmatrix
Architecture de circuit et procédé pour tester un réseau logique programmable

(43) Date of publication of application: 31.05.1995
(73) Proprietor: STMicroelectronics S.r.l., 20041 Agrate Brianza (Milano) (IT)
(72) Inventor: Maccarrone, Marco, I-27030 Palestro (PV) (IT); Olivo, Marco, I-24100 Bergamo (IT)
(74) Representative: Botti, Mario

(56) References cited:
- EP-A- 0 422 912
- US-A- 4 527 115
- IEEE INTERCON CONFERENCE RECORD vol. 17 , 12 May 1992 , NEW YORK US pages 271 - 276 JONES R. ET AL. 'Sub-Micron CMOS gate arrays with IEEE 1149.1 JTAG'

## Description

### Field of application

The present invention relates to a circuit architecture for the configuration of combinatory networks comprising a programmable logic matrix and which permits testing of said matrix.

More specifically the present invention relates to a combinatory network architecture comprising a programmable logic matrix of the PLA type connected between input and output latches and test and address information paths (BUS).

The present invention also relates to a method for testing and control of signals deriving from the PLA matrix.

### Prior art

As known, many digital devices such as for example microprocessors, memories and/or decoders contain a control unit provided by means of a state machine comprising a combinatory network provided through a programmable logic matrix and a battery of latches which memorises the state machine.

The programmable logic matrix is usually the PLA (Programmable Logic Array) type.

In combinatory networks of a certain complexity testing of the PLA is very important and especially if it is the dynamic type.

Indeed, the possible failures of a dynamic PLA are not tied only to the logical correctness of the network because it requires a precharging phase for the internal nodes. These nodes maintain their value in voltage only by capacitive effect. Therefor, any resistive discharge paths to ground are a problem.

To check the absence of failures in a structure of this type it is normally necessary to generate a sequence of so-called test vectors which supply the data to be applied at the input of the combinatory network and the sample outputs which should be the result of normal operation. Comparison of the real outputs of the device with the sample outputs permits identification of a malfunction of the PLA.

It is noted however that a dynamic PLA has a timed operation divided in precharge and evaluation which requires a synchronisation signal. To carry out the test it is necessary to accede to this signal by means of one of the external pins to the memory circuit.

Therefore, in accordance with the known art, to perform the test it is necessary to connect the PLA inputs with the outputs of one of the binary counters in the circuit.

In this manner it is necessary to perform a very long count to achieve a sufficient cover from possible failures. In particular, if the PLA has Ni input variables, to have a logic value '1' on the most significant bit by activating the transistors connected to said node it is necessary to perform 2Ni-1 clock cycles.

This operation obviously takes a long time for access which slows down the testing.

The technical problem at the base of the present invention is to conceive a combinatory network architecture comprising a PLA which would facilitate, make safer and speed up the PLA testing operations while overcoming the shortcomings of the known art.

Document EP-A-0 422 912 describes a logic circuit made of cells, said logic circuit being testable thanks to predetermined testing pathes and switching elements.

### Summary of the invention

The solution idea at the base of the present invention is to structure the combinatory network in such a manner as to use the input and output latches associated with the PLA to perform the testing.

On the basis of this solution idea the technical problem is solved by a circuit architecture of the type set forth above and defined in the characterising part of the annexed claims.

The characteristics and advantages of the circuit architecture in accordance with the present invention as defined in the independent claims are set forth in the description of an example of embodiment thereof given below by way of nonlimiting example with reference to the annexed drawings.

### Brief description of the drawings

In the drawings:

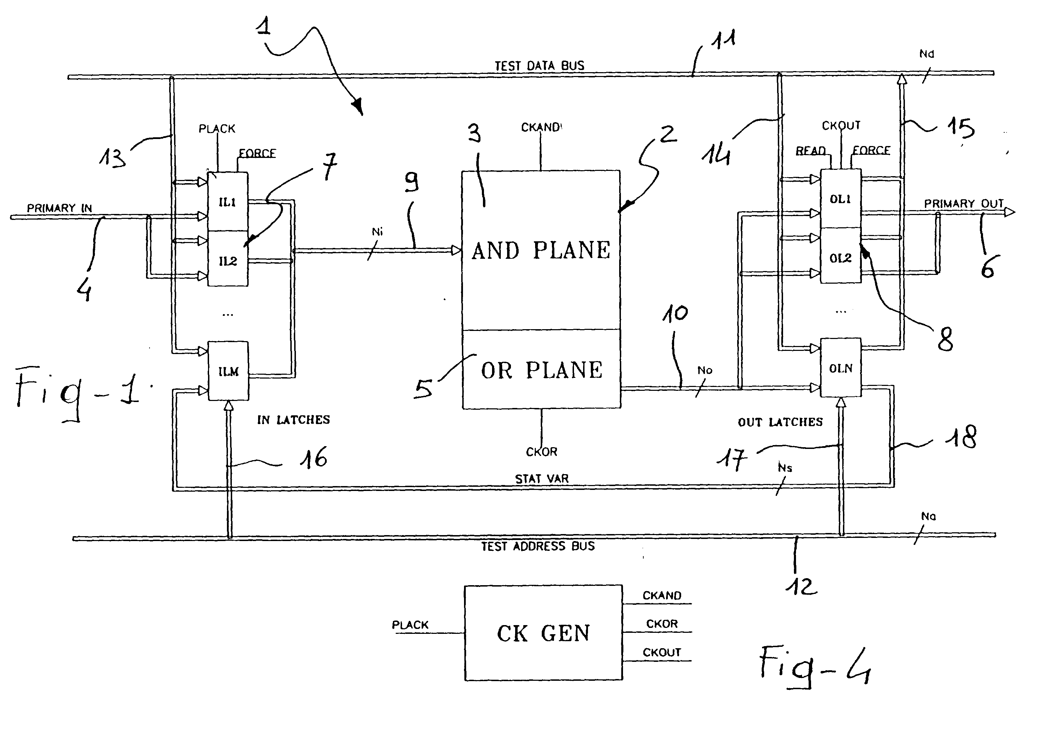

- FIG. 1 shows a schematic view of the circuit architecture in accordance with the present invention,
- FIG. 2 shows a detail of the architecture of FIG. 1,
- FIG. 3 shows another detail of the architecture of FIG. 1,
- FIG. 4 shows schematically a clock circuit associated with the architecture of FIG. 1,
- FIG. 5 shows a partial view of a block diagram of an integrated memory circuit incorporating the architecture of FIG. 1, and
- FIG. 6 shows schematically in greater detail a detail of FIGS. 2 and 3.

### Detailed description

With reference to the above figures reference number 1 indicates schematically as a whole a circuit architecture provided in accordance with the present invention to facilitate testing of a programmable logic matrix 2.

The matrix 2 is a combinatory network e.g. of the so-called Programmable Logic Array (PLA) type. Matrix 2 is structured in a first portion 3 of type AND enabled through a clock signal CKAND and in a second portion 5 of type OR enabled through a clock signal CKOR.

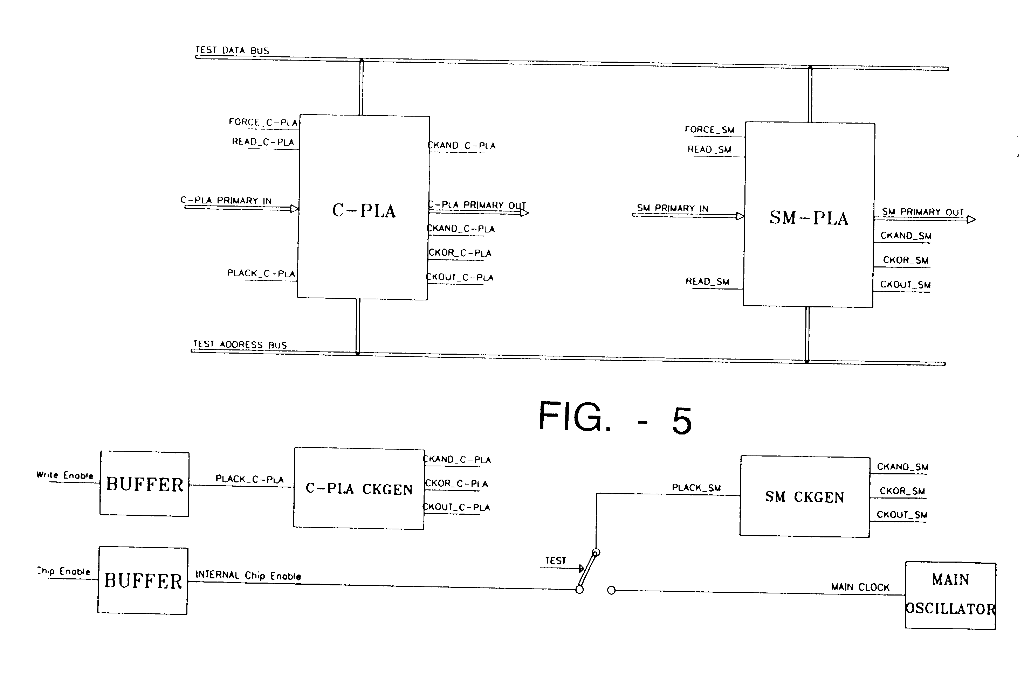

The signals CKAND and CKOR are produced by a generator CKGEN of synchronism frequencies visible in FIG. 4. Said generator can also be structurally independent of the architecture 1.

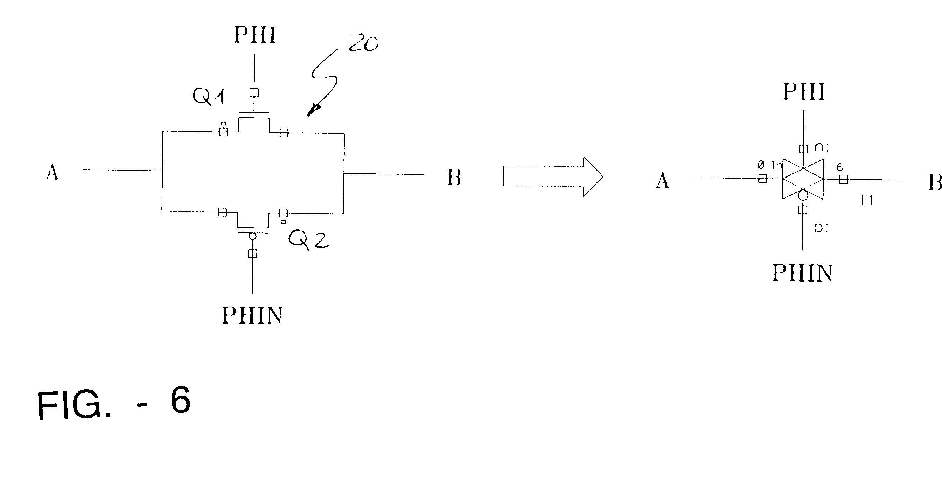

In greater detail, at least one pair of matrices 2 of the type set forth is incorporated in a non-volatile integrated memory circuit partially and schematically visible in FIG. 5. A first matrix C-PLA (Command PLA) is designed to interpret the commands supplied by the user, e.g. the commands 'read', 'write', 'erase', etc.

A second matrix SM-PLA (State Machine - PLA) governs performance of the internal algorithms. Either the first or the second receives respective synchronism signals from related generators CKGEN, the first of which operates on the basis of the clock signal received on the 'write enable' pin of the integrated memory circuit.

The second generator can operate on the basis of a synchronism pulse received from an internal oscillator ('Main Oscillator') or the 'Chip Enable' pin of the integrated circuit if in test mode. Switching between the two signals is piloted by a selector indicated by the sign TEST.

The architecture 1 also comprises a group 7 of input latches and a corresponding group 8 of output latches.

The input latches are in quantity M and are indicated individually by the signs IL1, IL2,..., ILM. The corresponding output latches are in quantity N and are indicated individually by the signs OL1, OL2,..., OLN.

The input latches IL1, IL2,..., ILM receive a synchronism signal PLACK produced by the generator CKGEN and an enablement signal indicated by the sign FORCE.

The output latches OL1, OL2,..., OLN receive a synchronism signal CKOUT produced by the generator CKGEN, a first enablement signal indicated by the sign FORCE and a second enablement signal indicated by the sign READ.

A bus 4 for primary connections collects the main inputs of the network in question.

The respective outputs of each of the latches ILi are connected at input to the portion 3 AND of the matrix 2 through a one-way information path 9 represented hereinafter by bus 9 with Ni bits.

The inputs of the corresponding output latches OLi are connected to the portion 5 OR of the matrix 2 through a one-way information path 10 represented hereinafter by bus 10 with No bits.

There is also provided a bus 6 for primary outputs which collects the principal outputs of the network.

The architecture 1 also comprises some connections expressly dedicated to the testability of the matrix 2.

A first data bus 11 with an Nd-bit path and a second address bus 12 with an Na-bit path are provided by opposing parts of the matrix 2.

Advantageously the bus 11 is connected electrically in parallel and in a one-way manner with respective inputs of the input latches IL1, IL2, ..., ILM through a branch 13. In addition, respective inputs of the output latches OL1, OL2, ..., OLN are in turn connected in parallel to the bus 11 through a one-way path 14.

In this manner it is possible to introduce from the exterior in the input and output latches some test configurations necessary for testing the PLA.

Advantageously, respective outputs of the output latches OL1, OL2, ..., OLN are connected to the bus 11 through a second one-way path 15. Clearly, nothing opposes the paths 14 and 15 coinciding with a single two-way path.

The other address bus 12 is connected electrically to the input latches 7 through a path 16 and to the output latches 8 through the path 17.

An Ns-bit connection 18 between an output of the latch OLN and an input of the latch ILM completes the structure of the architecture 1.

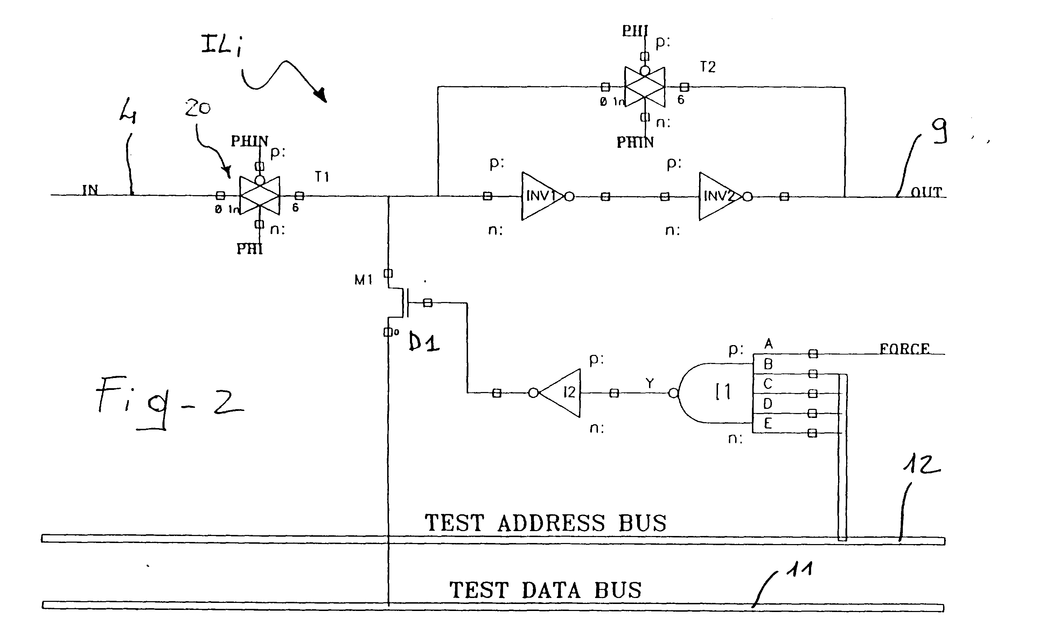

Now, with particular reference to the example of FIG. 2, there is described in detail the internal structure of a generic input latch ILi.

The data bus 11 is advantageously connected to the latch ILi through a field effect transistor and in particular an n-channel MOS M1 connected with its own drain terminal D1.

Said transistor has its gate terminal G1 connected electrically to the output of an inverter I2 which is in turn connected to the output of a logic gate I1 of the NAND type.

This logic gate I1 has four inputs (B,C,D,E) connected to the address bus 12 while a fifth input A receives directly the enablement signal FORCE.

The source terminal S1 of the transistor M1 is connected to a series of two inverters INV1 and INV2.

The output OUT of the second inverter INV2 is connected in feedback to the input of the first inverter INV1 with the interposition of a one-way element 20 (pass) which can be provided also by a transistor T2.

The structure of this element 20 is shown in greater detail in FIG. 6. It is particularly interesting to use a pair of transistors, one n-channel MOS indicated by Q1 and one p-channel MOS indicated by Q2 paired through double drain-source connections. The gate terminals of said transistors Q1 and Q2 receive enabling signals PHI and PHIL respectively.

At the input of the first inverter INV1 is applied also a signal IN transmitted on the bus 4 through a one-way (pass) element 20 which can be provided in the manner described with reference to FIG. 6 or also with a single transistor T1.

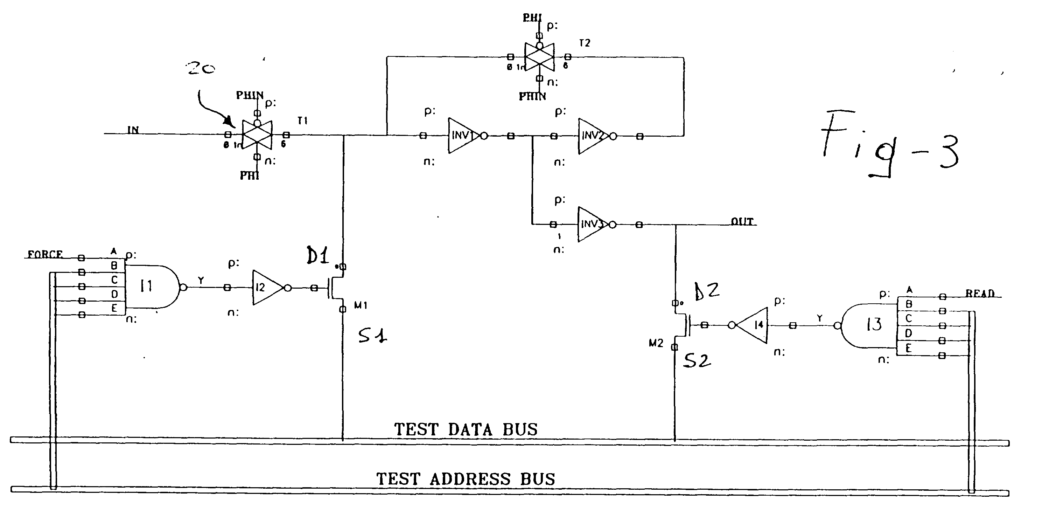

Now with particular reference to the example of FIG. 3 there is described in detail the internal structure of a generic output latch OLi.

The structure of the latch OL1 is similar to that of the input latch ILi and for it the details having the same function as in the above embodiment are indicated by the same reference signs.

The generic latch OLi is advantageously connected to the data bus 11 through two field effect transistors of the n-channel MOS type, M1 and M2, and through their source terminals S1 and S2.

Said transistors M1 and M2 have their gate terminals G1 and G2 connected electrically to the outputs of two inverters I2 and I4 respectively which have their inputs connected to the outputs of two logic gates I1 and I3 of the NAND type.

These logic gates have four inputs (B,C,D,E) connected electrically to the address bus 12. The fifth input A of the logic gate I3 receives the signal READ while the corresponding fifth input A of the logic gate I1 receives the signal FORCE.

The source terminal S1 of the transistor M1 is connected to the output of the element 20 which receives at input the signal IN and to the input of a series of inverters INV1 and INV2.

The output of the first inverter INV1 is connected also to the input of a third inverter INV3 whose output OUT is connected to the drain terminal D2 of the transistor M2.

The output of the second inverter INV2 is connected in feedback to the input of the first inverter INV1 through a second element 20.

The latches ILi and OLi have some peculiarities which are explained below.

In both the diagrams of FIGS. 2 and 3 it is seen that forcing of the data present on the data bus 11 is done by means of a single n-channel transistor without interdicting the feedback gate of T2. In this manner a check phase necessary for extinguishing T2 during loading of the data is saved. This is possible by means of the sizing adopted the transistors which calls for the use of resistive feedback transistors, i.e. with a small W:L ratio on which is made to prevail the datum imposed on the n-channel transistor M1 having a bigger W:L ratio.

In a similar manner the data stored in the latches is also read using a single n-channel transistor. This is made possible by the fact that, during reading, the data bus 11 is connected to a battery of resistive pull-ups which set a high logic condition thereof. When the datum to be read is a logical value '0' the n-channel transistor M1 lowers the line voltage. A small and entirely tolerable consumption is introduced in testing.

FIGS. 2 and 3 show how the input latch group 7 and output latch group 8 are equipped with an enablement logic for the test procedure (FORCE signals) and decoding of the input present on the address bus (the READ signal). These signals permit connection of latches 7 and 8 to buses 11 and 12.

Finally FIG. 4 shows schematically a clock signal generator CKGEN ,which supplies at the output the clock signals CKAND, which synchronizes the portion AND 3 of the PLA 2, CKOR, which synchronises the portion OR 5 of the PLA 2, CKOUT, which synchronises the output latches OLi, and PLACK, which synchronises the input latches ILi.

There is described below the test method in accordance with the present invention starting from an initial state in which the input latch 7 and output latch 8 are without informative content.

On the address bus 12 are input the addresses which permit activation of the various latches which contain the logic values of the internal nodes to be checked while on the data bus 11 are input just the logic check values.

For correct operation of the circuit architecture 1 it is necessary that each individual latch IL1, IL2, ..., ILM and OL1, OL2, ..., OLN have a parallelism less than or equal to that of the data bus 11, indicated by Nd, to be able to supply to the PLA a test logic state and memorise the output thereof while verifying normal operation.

In addition, to better exemplify the operating mechanism of the circuit there is shown the command of the decoding network on a single bit of the latches. In reality the decoding network pilots an entire element of the input/output latches and not just one bit.

The FORCE signal enables the input latches 7 for reception of data transmitted on the bus 11.

Similarly the FORCE signal also enables the output latches 8 for memorising therein the output state of the PLA. Through the READ signal it is then possible to read this logic state and evaluate consequently the operating conditions of the matrix 2.

Since the latch groups 7 and 8 are connected together through the Na-bit information path 12, it is necessary that each input and output latch be enabled by one of the possible combinations of the address bus 12 (equal to 2Na) to be able to select the line/column to be tested.

In greater detail, the steps of the method can be summarised as follows:
- by acting on the FORCE signal and the address bus 12 the input latches 7 IL1, IL2, ..., ILM are enabled in sequence by introducing through them the desired data which are transmitted on the bus 11;
- there is then performed a first evaluation cycle of the dynamic PLA by acting on its principal clock CKAND accessible from the exterior;
- the output latches OL1, OL2, ..., OLN are read in sequence through the READ signal and the address bus 12 so as to compare the outputs of the OR portion of the PLA with those available as the sample; and
- the procedure is started over with a new test vector.

By following this procedure it is also possible to perform tests calling for evolution of the machine for a desired number of steps by performing in sequence several evaluation phases such as that described.

In this case however it is necessary to keep the feedback path of the state variables which are normally broken by a special signal which inhibits the signals which pilot the PLA during performance of the test.

In addition, with circuit architecture in accordance with the present invention it is possible to directly force the output latches 8 through the FORCE signal and use them thus as normal test latches to check the signals emerging from the PLA under normal operating conditions.

Finally, division in blocks of the input and output latches permits keying in of the data through a bus having parallelism less than the number of input variables.

The architecture and testing method in accordance with the present invention are surely advantageous:
- in terms of surface area of integrated circuit occupied, and
- in terms of speed of performance of the testing procedure.

Indeed, to propeprly cover failures it is no longer necessary to perform a count of at least 2Ni-1 clock cycles. With the present circuit implementation it is sufficient to apply only the input combinations actually necessary, generating an appropriate sequence of tests suited to the content of the PLA in question. This method then permits a considerable savings in time for test performance.

This is achieved merely by implementing a circuit architecture which connects the input and output latches with the data buses 11 and address buses 12.

This implementation is particularly easy in the greater part of the devices already set up for inspectability and hence equipped with the necessary signals for this approach. But the possibility of optional modifications and variations for other types of circuits, all falling in the scope of the invention, as defined in the claims set forth below, is not eliminated.

## Claims

1. Circuit architecture (1) for testing a programmable logic matrix (2) e.g. type PLA and of the type comprising a series (7) of input latches (ILi) and a corresponding series (8) of output latches (OLi) connected to the matrix (2) and test information paths structured with at least one data bus (11) and one address bus (12) and characterised in that said input latches (7) and output latches (8) are connected electrically to the test data bus (11) and the test address bus (12).

2. Circuit architecture in accordance with claim 1 characterised in that the input latches (7) have respective inputs connected to the test data bus (11) and the test address bus (12).

3. Circuit architecture in accordance with claim 2 characterised in that the connection between said inputs and said busses (11,12) is one-way.

4. Circuit architecture in accordance with claim 1 characterised in that the output latches (8) have respective inputs connected to the test data bus (11) and the test address bus (12).

5. Circuit architecture in accordance with claim 1 characterised in that the output latches have respective outputs connected only to the test data bus (11).

6. Circuit architecture in accordance with claim 1 characterised in that the output latches (8) are connected in a two-way manner to the test data bus (11).

7. Circuit architecture in accordance with claim 1 characterised in that in each input latch (ILi) is provided a single field effect transistor (M1) having a terminal (D1) connected directly to the test data bus (11).

8. Circuit architecture in accordance with claim 1 characterised in that in each output latch (OLi) is provided a first field effect transistor (M1) having a terminal (S1) connected to the data bus (11) and a second terminal (D1) connected to the latch input and a second field effect transistor (M2) having a terminal S2 connected to the data bus (11) and a second terminal (D2) connected to the latch output.

9. Method for testing a programmable logic matrix, e.g. the PLA type, inserted in a circuit architecture (1) comprising a series (7) of input latches (ILi) and a corresponding series (8) of output latches (OLi) connected to the matrix (2) and test information paths structured with at least one data bus (11) and one address bus (12) and characterised in that it provides direct electrical connections between said input and output latches (7,8) and the test data and address busses (11,12).

10. Method in accordance with claim 9 characterised in that the input and output latches (7,8) have a parallelism less than or equal to that of the data bus (11).

## Patentansprüche

1. Schaltungsaufbau (1) zum Testen einer programmierbaren Logikmatrix (2), beispielsweise vom Typ PLA, und vom Typ mit einer Reihe (2) von Eingangszwischenspeichern (ILi) und einer entsprechenden Reihe (8) von Ausgangszwischenspeichern (OLi), die an die Matrix (2) angeschlossen sind, mit Testinformationspfaden, die mit mindestens einem Datenbus (11) und einem Adressenbus (12) aufgebaut sind,
dadurch gekennzeichnet, daß
die Eingangszwischenspeicher (7) und die Ausgangszwischenspeicher (8) elektrisch an den Testdatenbus (2) und den Testadressenbus (12) angeschlossen sind.

2. Schaltungsaufbau nach Anspruch 1,
dadurch gekennzeichnet, daß
die Eingangszwischenspeicher (7) jeweilige Eingänge aufweisen, die an den Testdatenbus (11) und an den Testadressenbus (12) angeschlossen sind.

3. Schaltungsaufbau nach Anspruch 2,
dadurch gekennzeichnet, daß
die Verbindung zwischen Eingängen und den Bussen (11, 12) eine Einbahnverbindung ist.

4. Schaltungsaufbau nach Anspruch 1,
dadurch gekennzeichnet, daß
die Ausgangszwischenspeicher (8) jeweilige Eingänge besitzen, die mit dem Testdatenbus (11) und dem Testadressenbus (12) verbunden sind.

5. Schaltungsaufbau nach Anspruch 1,
dadurch gekennzeichnet, daß
die Ausgangszwischenspeicher Ausgänge aufweisen, die nur mit dem Testdatenbus (11) verbunden sind.

6. Schaltungsaufbau nach Anspruch 1,
dadurch gekennzeichnet, daß
die Ausgangszwischenspeicher (8) als Zwei-Wege-Verbindung mit dem Testdatenbus (11) verbunden sind.

7. Schaltungsaufbau nach Anspruch 1,
dadurch gekennzeichnet, daß
jeder Eingangszwischenspeicher (ILi) mit einem einzelnen Feldeffekttransistor (M1) ausgestattet ist, der einen Anschluß (D1) besitzt, welcher direkt mit dem Testdatenbus (11) gekoppelt ist.

8. Schaltungsaufbau nach Anspruch 1,
dadurch gekennzeichnet, daß
jeder Ausgangszwischenspeicher (OLi) mit einem ersten Feldeffekttransistor (M1) ausgestattet ist, der einen mit dem Datenbus (11) verbundenen Anschluß (S1) aufweist und einen mit dem Zwischenspeichereingang verbundenen zweiten Anschluß (D1) aufweist, ferner einen zweiten Feldeffekttransistor (M2) besitzt, der einen an den Datenbus (11) gekoppelten Anschluß S2 und einen mit dem Zwischenspeicherausgang verbundenen zweiten Anschluß (D2) besitzt.

9. Verfahren zum Testen einer programmierbaren Logikmatrix, z.B. vom PLA-Typ, eingefügt in einen Schaltungsaufbau (1) mit einer Reihe (7) von Eingangszwischenspeichern (ILi) und einer entsprechenden Reihe (8) von Ausgangszwischenspeichern (OLi), die an die Matrix (2) und Testinformationspfade angeschlossen sind, die mit mindestens einem Datenbus (11) und einem Adressenbus (12) aufgebaut sind,
dadurch gekennzeichnet, daß
es für direkte elektrische Verbindungen zwischen den Eingangs- und Ausgangszwischenspeichern (7, 8) einerseits und den Testdaten- und Adressenbussen (11, 12) andererseits sorgt.

10. Verfahren nach Anspruch 9,
dadurch gekennzeichnet, daß
die Eingangs- und Ausgangszwischenspeicher (7, 8) eine Parallelität aufweisen, die kleiner als oder genauso groß ist wie diejenige des Datenbusses (11).

## Revendications

1. Architecture de circuit (1) pour tester une matrice logique programmable (2), par exemple de type réseau logique programmable, et du type comprenant une série (7) de circuits de verrouillage d'entrée (ILi) et une série correspondante (8) de circuits de verrouillage de sortie (OLi) connectés à la matrice (2) et des chemins d'informations de test structurés avec au moins un bus de données (11) et un bus d'adresses (12) et caractérisée en ce que lesdits circuits de verrouillage d'entrée (7) et circuits de verrouillage de sortie (8) sont connectés électriquement au bus de données de test (11) et au bus d'adresses de test (12).

2. Architecture de circuit selon la revendication 1 caractérisée en ce que les circuits de verrouillage d'entrée (7) ont des entrées respectives connectées au bus de données de test (11) et au bus d'adresses de test (12).

3. Architecture de circuit selon la revendication 2 caractérisée en ce que la connexion entre lesdites entrées et lesdits bus (11,12) est unidirectionnelle.

4. Architecture de circuit selon la revendication 1 caractérisée en ce que les circuits de verrouillage de sortie (8) ont des entrées respectives connectées au bus de données de test (11) et au bus d'adresses de test (12).

5. Architecture de circuit selon la revendication 1 caractérisée en ce que les circuits de verrouillage de sortie (8) ont des sorties respectives connectées seulement au bus de données de test (11).

6. Architecture de circuit selon la revendication 1 caractérisée en ce que les circuits de verrouillage de sortie (8) sont connectés au bus de données de test (11) selon un mode bidirectionnel.

7. Architecture de circuit selon la revendication 1 caractérisée en ce qu'il est prévu, dans chaque circuit de verrouillage d'entrée (ILi), un unique transistor à effet de champ (M1) ayant une électrode (D1) connectée directement au bus de données de test (11).

8. Architecture de circuit selon la revendication 1 caractérisée en ce qu'il est prévu, dans chaque circuit de verrouillage de sortie (OLi), un premier transistor à effet de champ (M1) ayant une électrode (S1) connectée au bus de données (11) et une seconde électrode (D1) connectée à l'entrée du circuit de verrouillage et un second transistor à effet de champ (M2) ayant une électrode (S2) connectée au bus de données (11) et une seconde électrode (D2) connectée à la sortie du circuit de verrouillage.

9. Procédé pour tester une matrice logique programmable, par exemple de type réseau logique programmable, insérée dans une architecture de circuit (1) comprenant une série (7) de circuits de verrouillage d'entrée (ILi) et une série correspondante (8) de circuits de verrouillage de sortie (OLi) connectés à la matrice (2) et des chemins d'informations de test structurés avec au moins un bus de données (11) et un bus d'adresses (12) et caractérisé en ce qu'il est prévu des connexions électriques directes entre lesdits circuits de verrouillage d'entrée et de sortie (7,8) et les bus de données et d'adresses de test (11,12).

10. Procédé selon la revendication 9, caractérisé en ce que les circuits de verrouillage d'entrée et de sortie (7,8) ont un parallélisme inférieur ou égal à celui du bus de données (11).
